# EUROPEAN PATENT SPECIFICATION

(11) **EP 3 896 832 B1**
(45) Date of publication and mention of the grant of the patent: **14.06.2023**
(21) Application number: 20869411.7
(22) Date of filing: 22.02.2020
(51) Int. Cl.: H02M 3/07, H02M 1/00, H03K 3/033

(54) **POWER SUPPLY MODULE, AND MEMORY DEVICE**
STROMVERSORGUNGSMODUL UND SPEICHERVORRICHTUNG
MODULE D'ALIMENTATION ÉLECTRIQUE ET DISPOSITIF DE MÉMOIRE

(30) Priority: 27.09.2019 CN 201910922840
(43) Date of publication of application: 20.10.2021
(73) Proprietor: Changxin Memory Technologies, Inc., Anhui 230000 (CN)
(72) Inventor: JI, Rumin, Hefei, Anhui 230000 (CN)
(74) Representative: V.O.
(86) International application number: PCT/CN2020/076310
(87) International publication number: WO 2021/056957

(56) References cited:
- EP-A1- 0 127 858
- CN-A- 105 553 260
- CN-A- 107 393 575
- CN-A- 107 979 359
- CN-A- 110 233 570
- US-A- 5 134 315
- US-A- 5 883 501
- US-A1- 2007 096 708
- US-A1- 2009 309 566
- US-A1- 2013 321 045
- CORTES JORGE ET AL: "Improved Transient Response of Controllers by Synchronizing the Modulator With the Load Step: Application to V2Ic", IEEE TRANSACTIONS ON POWER ELECTRONICS, INSTITUTE OF ELECTRICAL AND ELECTRONICS ENGINEERS, USA, vol. 30, no. 3, 1 March 2015 (2015-03-01), pages 1577-1590, XP011561480, ISSN: 0885-8993, DOI: 10.1109/TPEL.2014.2314242 [retrieved on 2014-10-14]

## Description

### CROSS REFERENCES TO RELATED APPLICATIONS

This application claims the benefit of priority to Chinese Patent Application No.201910922840.6 filed on September 27, 2019, entitled "POWER SUPPLY MODULE AND MEMROY DEVICE".

### TECHNICAL FIELD

The present disclosure relates to the field of integrated circuits, and in particular to a power module and a memory device. US2009309566 A1 discloses a charge pump circuit.

### BACKGROUND

Various power modules, such as a charge pump, a linear regulator, etc. are needed in a Dynamic Random Access Memory (DRAM) chip, for powering different functional modules (such as word line drive voltage VPP, back gate bias voltage VBB, bit line pre-charge voltage VCC/2, etc.). During the operation process of the DRAM chip, various operation modes are frequently switched. In different operation modes, the current drawn by each functional module may be different from one another, which causes the output voltage of the power module to change. For example, in a low power consumption mode, when a heavy load suddenly occurs, the output voltage of the power module is pulled down quickly, and there is a certain delay for the voltage module to start voltage boost, during the time period of the delay, there is no extra energy to supply, meanwhile the output voltage of the voltage module continues to decrease, resulting in a large undershot of the output voltage, which affects the subsequent operations of other modules.

Therefore, how to enhance the transient response of the power module has become a technical problem that needs to be solved urgently.

### SUMMARY

The present disclosure provides a power module and a memory device to improve the transient response capability of the power module, thereby improving the stability of the memory device.

The present invention is defined in the independent claim, and the preferable features according to the present invention are defined in the dependent claims.

The power module of the present disclosure can supplement energy to the boosting unit in time after detecting the voltage drop at the output of the power supply, and adjust the output back to the normal voltage, so that the output of the power supply can be supplemented with energy without waiting. Thereby, the output voltage drop is reduced and errors in subsequent circuits are prevented.

### BRIEF DESCRIPTION OF THE DRAWINGS

By describing its exemplary embodiments in detail with reference to the accompanying drawings, the above and other objectives, features and advantages of the present disclosure will become more apparent.
FIG. 1a is a schematic diagram of the structure of a power module in the prior art;
FIG. 1b is a schematic time sequence of various signals of the power module in the prior art;
FIG. 2 is a schematic diagram of the structure of a power module according to some embodiments of the present disclosure;
FIG. 3 is a schematic diagram of a boosting unit of a power module according to some embodiments of the present disclosure;
FIG. 4 is a schematic timing diagram of various signals in the power module in some embodiments of the present disclosure;
FIG. 5a is a schematic diagram of the circuit structure of a pulse generator of a power module according to some embodiments of the present disclosure;
FIG. 5b is a schematic diagram of the circuit structure of a pulse generator of a power module according to some embodiments of the present disclosure; and
FIG. 6 is the timing diagram illustrating changes of the output voltage of the power module in an embodiment of the present disclosure and in the prior art.

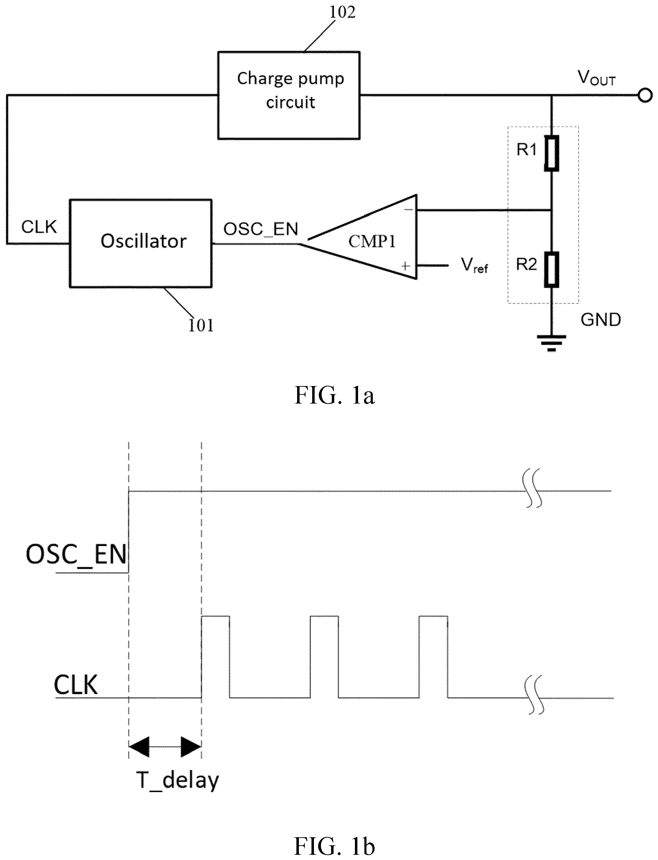

Listed below are definitions of various reference numbers in FIGs. 1-6:
101 oscillator;
102 charge pump circuit;
201 boosting unit;
202 enabling unit;
2021 voltage divider circuit;
203 control unit;
2031 oscillator;
2032 pulse generator;
2033 "or" operation unit;
601 delay inversion Circuit;
602 "and" operation unit;
Vout power output;
R1 resistor;
R2 resistor;
R' resistor;
CMP1 comparator;
CMP2 comparator;
Vref reference voltage;
OSC_EN enabling signal;
OSC_EN2 enabling signal;
CLK boost control Signal;
CLK2' boost control signal;
T_delay delay;
T delay time;
INV invertor;
INV4 invertor;
C' capacitor;
C3 capacitor;
M1 transistor;
M2 transistor;
CLOAD load capacitor;
Vcc power supply;
R11 first voltage division resistor;
R12 second voltage division resistor;
Vref2 reference voltage;
CLK2 delayed pulse control signal;
one-shot instant pulse control signal;
NOR1 NOR gate;
NOT1 NOT gate;
NOT2 NOT gate;
INV1 first invertor;
INV2 Second invertor;
INV3 third invertor;
C1 first capacitor;
C2 second capacitor;
NAND1 NAND gate;
NOT2 invertor; and
ILOAD load current.

### DETAILED DESCRIPTION

As described in the background art, the response of an existing power module is relatively slow, which often leads to the problem of unstable output voltage.

Please refer to FIG. 1a, which is a schematic diagram of the structure of a power module in the prior art.

The power module includes: a charge pump circuit 102, a power output Vout is configured to output a power supply voltage to the load, the power output Vout is connected to a resistor R1 and a resistor R2 connected in series to the ground, and the resistor R1 and the resistor R2 form a voltage divider circuit, the connection node of the resistor R1 and the resistor R2 is connected to the negative input of the comparator CMP1, the positive input of the comparator CMP1 is connected to the reference voltage Vref, and the output of the comparator CMP1 is connected to the oscillator 101, is further connected to the charge pump circuit 102 through the output of the oscillator 101.

In the low power consumption mode, the input voltage of the negative input of the comparator CMP1 is greater than the reference voltage Vref, and the output enabling signal OSC_EN of the comparator CMP1 is low. At this time, the oscillator 101 is turned off to save power. In this mode, if the load on the power output Vout suddenly becomes heavy, the output power supply voltage Vout is pulled down quickly, the output enabling signal OSC_EN of the comparator CMP1 is at high level, and the oscillator 101 is enabled. The oscillator 101 is enabled in response to receiving the enabling signal OSC_EN, and there is a delay T_delay (please refer to Figure 1b) from the time when the enabling signal OSC_EN is received to the time when a pulse signal CLK is output. During the time period of the delay, no energy is supplied to the output capacitor of the charge pump circuit 102, so the output voltage Vout continues to drop, resulting in a large drop in the output voltage Vout, which affects the stability of the subsequent modules.

It can be seen that reducing the pulse delay of the boost control signal CLK for controlling the boost of the charge pump circuit 102 can reduce the drop of the output voltage Vout, and produce energy to the charge pump circuit 102 in time to stabilize the output power supply voltage.

Based on this, a new power module is proposed, which can respond quickly when the load suddenly becomes heavy, to reduce the drop of the output voltage.

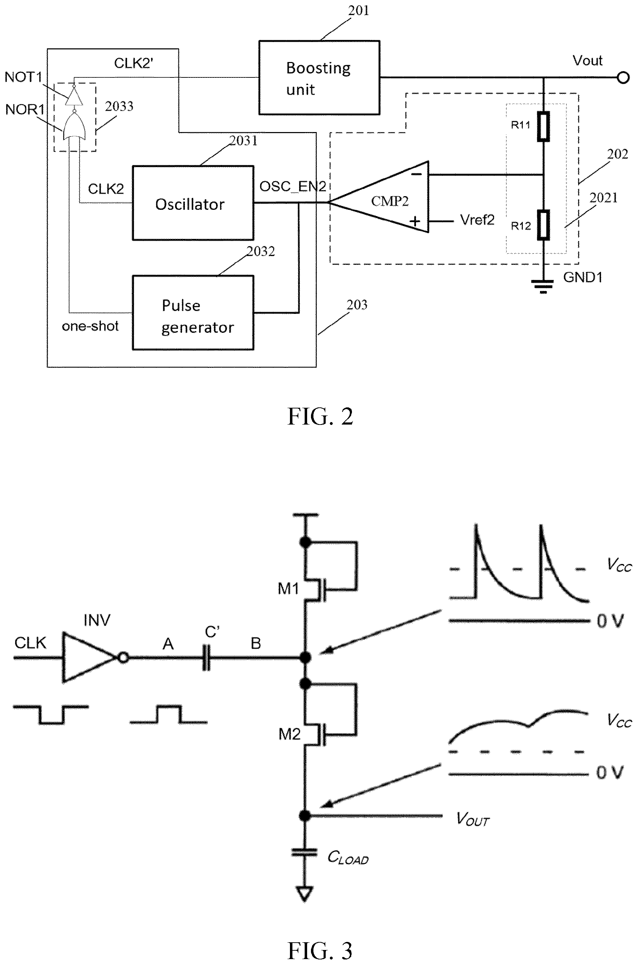

FIG. 2 is a schematic diagram of the structure of a power module according to some embodiments of the present disclosure.

In this embodiment, the power module includes: a boosting unit 201, an enabling unit 202, and a control unit 203.

The boosting unit 201 has a power output Vout for outputting a power supply voltage Vout.

The boosting unit 201 includes a load capacitor, one end of the load capacitor serves as a power output Vout, and the load capacitor is charged to output a power supply voltage. When the output drops, the output voltage can be pulled up by supplementing energy to the load capacitor. In an embodiment of the present disclosure, the boosting unit 201 may be a charge pump circuit.

FIG. 3 is a schematic diagram of the circuit structure of the boosting unit 201 according to some embodiments of the present disclosure.

In this embodiment, the boosting unit 201 includes an invertor INV, a capacitor C', a transistor M1 and a transistor M2, and a load capacitor C_{LOAD}. The drain of the transistor M1 is connected to the power source Vcc, the source of the transistor M1 is connected to the drain of the transistor M2, the source of the transistor M2 is connected to the first terminal of the load capacitor C_{LOAD}, and the second terminal of the load capacitor C_{LOAD} is grounded. The gates of the transistor M1 and the transistor M2 are both connected to their respective drains. The input of the invertor INV is used to input the boost control signal CLK, the output of the invertor INV is connected to the first terminal A of the capacitor C', and the other end B of the capacitor C' is connected to the connecting terminal between the transistors M1 and M2. The capacitor C' is charged by the boost control signal CLK, thereby supplementing energy to the load capacitor C_{LOAD} and increasing the power supply voltage output by the first terminal of the load capacitor C_{LOAD}.

In other embodiments, the boosting unit 201 may also adopt a charge pump circuit of another structure, or adopt a boosting unit of another structure that can be controlled by a pulse signal. Those skilled in the art can reasonably select a suitable circuit structure as the boosting unit 201 according to the requirements of the output voltage of the power module.

The enabling unit 202 is connected to the power output Vout for generating an enabling signal, and when the voltage of the power output Vout drops to a set value, the enabling signal generates a rising edge. The enabling unit 202 is configured to detect the voltage of the power output Vout.

In this implementation, the enabling unit 202 includes a voltage divider circuit 2021 and a comparator CMP2. One end of the voltage divider circuit 2021 is connected to the power output Vout, and the other end of the voltage divider circuit 2021is grounded to GND1. The output of the voltage divider circuit 2021 is connected to the negative input of the comparator CMP2, and the positive input of the comparator CMP2 is connected to the reference voltage terminal, and the reference voltage value Vref2 is a set value.

The voltage at the output of the voltage divider circuit 2021 varies with the voltage at the output voltage Vout of the power module, and preferably, is proportional to the voltage at the output Vout of the power module, and can accurately reflect amplitudes and changes of the output voltage of the output Vout of the power module. In this embodiment, the voltage divider circuit 2021 includes a first voltage dividing resistor R11 and a second voltage dividing resistor R12, a first terminal of the first voltage dividing resistor R11 is connected to the power output Vout, and the second terminal of the first voltage dividing resistor R11 is connected to the first terminal of the second voltage dividing resistor R12, the second terminal of the second voltage dividing resistor R12 is grounded to GND1, the connecting terminal of the first voltage dividing resistor R11 and the second voltage dividing resistor R12 serves as the output of the voltage divider circuit 2021. The resistances of the first voltage dividing resistor R11 and the second voltage dividing resistor R12 can be selected rationally according to the requirement of the voltage division ratio. In other implementations, the voltage divider circuit 2021 may also have other circuit structures. In other embodiments, the voltage divider circuit 2021 of the enabling unit 202 may also be another circuit structure capable of monitoring the output voltage Vout of the power module at any time.

When the output voltage Vout of the power module is high, the voltage value output by the voltage divider circuit 2021 to the negative input of the comparator CMP2 is greater than the reference voltage Vref2 at the positive input of the comparator CMP2, and the enabling signal OSC_EN2 output by the comparator CMP2 is low, the oscillator 2031 is turned off. When the power supply voltage Vout decreases, the voltage value of the voltage divider circuit 2021 output to the negative input of the comparator CMP2 is less than the reference voltage Vref2 of the positive input, then the enabling signal OSC_EN2 output by the comparator CMP2 generates a rising edge, which forms a high level signal, and triggers the oscillator 2031 to operate.

The enabling unit 202 outputs an enabling signal OSC_EN2 corresponding to the voltage change of the output voltage Vout of the power module.

The control unit 203 includes: an oscillator 2031, a pulse generator 2032, and an OR operation unit 2033.

The input of the oscillator 2031 is connected to the output of the enabling unit 202. When the enabling signal OSC_EN2 is at a high level, the oscillator 2031 is triggered by the enabling signal OSC_EN2 for generating a certain periodic delayed pulse control signal CLK2.

The pulse generator 2032 is connected to the output of the enabling unit 202, and is configured to synchronously generate an instant pulse control signal one-shot while receiving the rising edge of the enabling signal OSC_EN2. In this specific embodiment, the pulse generator 2032 is triggered by the rising edge of the enabling signal OSC_EN2 to generate the instant pulse control signal "one-shot" as a single pulse signal, that is, there has only one pulse.

The "OR" operation unit 2033 is connected to the outputs of the oscillator 2031 and the pulse generator 2032, and performs "OR" calculation on the delayed pulse control signal CLK2 and the instant pulse control signal "one-shot" to generate the boost control signal CLK2'.

In this implementation, the "OR" operation unit 2033 includes a NOR gate NOR1 and a NOT gate NOT1 connected in sequence, and two inputs of the NOR gate NOR1 are connected to the output of the pulse generator 2032 and the output of the oscillator 2031 respectively, the output of the NOR gate NOR1 is connected to the input of the NOT gate NOT1, and the output of the NOT gate NOT1 is connected to the input of the boosting unit 201 .

The output of the control unit 203 is connected to the boosting unit 202 for outputting the boost control signal CLK2' to the boosting unit 202, and controlling the boosting unit 202 to increase the output voltage of the power module.

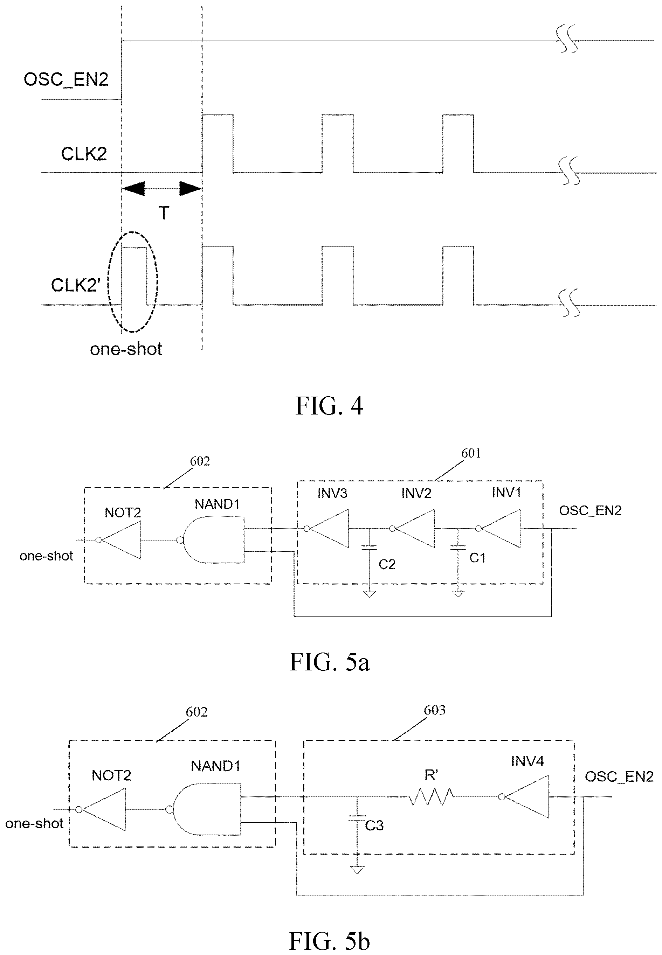

FIG. 4 is a timing diagram of various signals in the power module in an embodiment of the present disclosure.

In this embodiment, when the load of the power output Vout becomes heavy, the output voltage decreases, so that the enabling signal OSC_EN2 becomes a high level, so that the oscillator 2031 is enabled and outputs a delayed pulse control signal CLK2. Because of the circuit characteristics of the oscillator 2031, the first pulse of the delayed pulse control signal CLK2 is later than the time instant that the enabling signal OSC_EN2 turns to a high level (that is, the rising edge moment), and the delay time is T.

Once the pulse generator 2032 receives the high-level enabling signal OSC EN2, it generates an instant pulse control signal "one-shot", and the rising edge of the instant pulse control signal one-shot is basically aligned with the rising edge of the enabling signal OSC_EN2 , both being generated at the same time or almost at the same time.

The "OR" operation unit 2033 performs an "OR" operation on the delayed pulse control signal CLK2 and the instant pulse control signal "one-shot" to generate a boost control signal CLK2'. Within the delay time T, the boost control signal CLK2' is an instant pulse of the instant pulse control signal "one-shot", followed by the delayed pulse control signal CLK2.

When detecting the voltage drop of the output voltage of Vout of the power module and the enabling signal OSC_EN2 turning into a high level, the power module of the present disclosure immediately generates a pulse of the boost control signal CLK2' to supplement the energy of the boosting unit 201 in time to increase the voltage at the output Vout of the power module, so that the output voltage is adjusted back to normal. Since the instant pulse control signal "one-shot" is generated immediately when the oscillator 2031 is enabled, and the output voltage Vout of the power module is supplied with energy via the boosting unit 201, the output voltage Vout does not need to wait for time T to obtain energy supplementation, and thus it can reduce the output voltage drop and prevent errors in subsequent circuits.

The pulse generator 2032 includes a delay inversion circuit and an "AND" operation unit; the input of the delay inversion circuit is connected to the output of the enabling unit 202 for inverting the enabling signal and output the inverted enabling signal with a delay; the "AND" operation unit is connected to the output of the delay inversion circuit and the output of the enabling unit 202, and performs an "AND" calculation between the signal output by the delay inversion circuit and the enabling signal.

FIG. 5a is a schematic structural diagram of a pulse generator according to an embodiment of the present disclosure.

The pulse generator 2032 includes a delay inversion circuit 601 and an "AND" operation unit 602.

The delay inversion circuit 601 includes: a first invertor INV1, a second invertor INV2, a third invertor INV3, a first capacitor C1 and a second capacitor C2. The input of the first invertor INV1 is connected to the output of the enabling unit 202, and the output of the first invertor INV1 is connected to the first terminal of the first capacitor C1 and to the input of the second invertor INV2. The output of the second invertor INV2 is connected to the first terminal of the second capacitor C2 and to the input of the third invertor INV3. The second terminals of the first capacitor C1 and the second capacitor C2 are all grounded. The output of the third invertor INV3 serves as the output of the delay inversion circuit 601.

The "AND" operation unit 602 includes a NAND gate NAND1, and a gate NOT2 connected to the gate NAND1. The two inputs of the NAND gate NAND1 are connected to the output of the enabling unit 202 and the output of the delay inversion circuit 601 respectively. The output of the NAND gate NAND1 is connected to the input of the NOT gate NOT2, and the output of the NOT gate NOT2 serves as the output of the pulse generator 2032.

The delay inversion circuit 601 includes a first capacitor C1 and a second capacitor C2. When the enabling signal OSC_EN2 output from the enabling unit 202 turns high, it is necessary to charge the capacitors C1 and C2 first before outputting an inverted enabling signal OSC_EN2, which means the enabling signal has a low level output to the "and" operation unit 602 after a delay. Therefore, the "AND" operation unit 602 performs an AND operation to the enabling signal OSC_EN2 and the delay inversion circuit 601, and outputs a high level for a certain period of time. After the delay inversion circuit 601 outputs a low level, the AND operation unit 602 outputs low level. Therefore, the pulse generator 2032 generates a high level at the moment when OSC_EN2 changes to a high level and within a certain period of time, and then generate a low level, thereby forming an instant control pulse "one-shot". The pulse width of the real-time control pulse "one-shot" can be varied by adjusting the first capacitor C1 and the second capacitor C2, so as to avoid the energy supplement of the boosting unit 201 from being too small due to the pulse width being too small, or the energy supplement of the boosting unit 201 from being too large due to the pulse width being too wide, resulting in an overshoot of the output voltage. The pulse width of the "one-shot" is adjusted to be the same with the pulse width generated by the oscillator 203.

FIG. 5b is a schematic structural diagram of a pulse generator according to another embodiment of the present disclosure.

In this embodiment, another circuit structure of the delay inversion circuit 603 is provided. The delay inversion circuit 603 includes an invertor INV4, a resistor R', and a capacitor C3. The input of the invertor INV4 is connected to the output of the enabling unit 202, and the output of the invertor INV4 is connected to the first terminal of the resistor R', the second terminal of the resistor R' is connected to the first terminal of the capacitor C3, the second terminal of the capacitor C3 is grounded, and the first terminal of the capacitor C3 serves as the output of the delay inversion circuit 603.

The delay inversion circuit 603 includes a capacitor C3. When the enabling signal OSC_EN2 output from the enabling unit 202 changes to a high level, the capacitor C3 needs to be charged before the enabling signal OSC_EN2 can be inverted, which means, only after a period of delay, the low level output can be sent to the "AND" operation unit 602. Therefore, the "AND" operation unit 602 performs an AND operation between the enabling signal OSC_EN2 and the delay inversion circuit 603, and outputs a high level for a certain period of time, and the AND operation unit 602 outputs a low level only after the delay inversion circuit 603 outputs a low level. Therefore, the pulse generator 2032 still generates a high level when a rising edge appears and then a high level lasts for a certain period of time for the enabling signal OSC_EN2, then changes to a low level, thereby generating an instant control pulse "one-shot".

In this embodiment, the charging time for the capacitor C3 can be adjusted by adjusting the size of the capacitor C3 and the size of the resistor R', thereby adjusting the pulse width of the "one-shot" instant pulse.

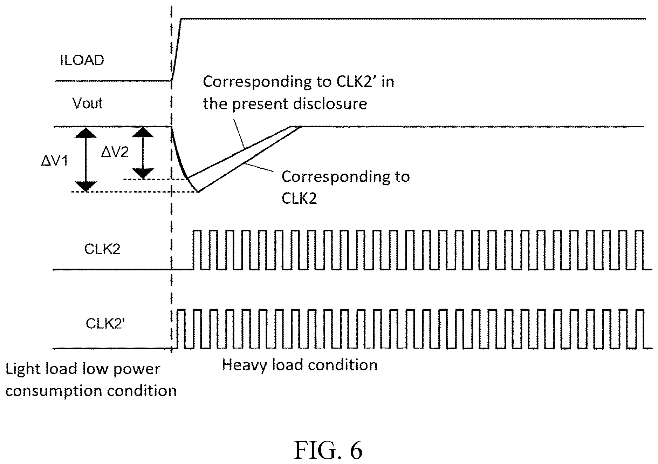

FIG. 6 shows the timing sequence diagram illustrating the changes of the output voltage of the power module in an embodiment of the present disclosure and in the prior art.

In the prior art, when in a heavy load state, the load current I_{LOAD} increases, which causes the output voltage Vout to decrease. Only the delayed pulse signal CLK2' output by the oscillator is used to supplement energy to the boosting unit 201 (referring to the FIG. 6) to increase the voltage at the output Vout of the power module. Since the delayed pulse signal CLK2' is generated after a period of delay since the output voltage Vout of the power module drops, the power supply voltage is decreased by ΔV1 and then increased gradually.

In the embodiment of the present disclosure, a pulse signal is generated instantly in the pulse of the boost control signal CLK2' after Vout drops, so as to reduce the amount of voltage drop at the power output Vout. The voltage at the power output Vout is decreased by ΔV2 and then increased gradually, where ΔV2<ΔV1.

Here, the power module is in the light load and low power consumption mode, the oscillator 203 will also generate a pulse signal with a larger clock interval to maintain the stability of the output voltage Vout.

The power module of the above embodiments can instantly respond to the drop of the output voltage of the power module, and is able to adjust the output voltage back to a normal level, thereby improving the response speed of the power module.

The specific implementation of the present disclosure also provides a memory, such as a DRAM memory, using the above-mentioned power module. The power module can be used to provide a word line driving voltage, bit line pre-charging voltage, in order to provide a stable power supply voltage to the memory. During the operation process of the memory chip, the memory chip frequently switches between various operation modes, the loads of the various module are changed, and when the load current is changed, the output voltage can be adjusted in time, to maintain a stable power supply voltage output, thereby improving the reliability and stability of the memory.

The protection scope of the invention is defined by the appended claims.

## Claims

1. A power module, comprising
a boosting unit (201), wherein the boosting unit (201) has a power output for outputting a power supply voltage;
an enabling unit (202), wherein the enabling unit (202) is connected to the power output and is configured to generate an enabling signal, wherein a rising edge occurs in the enabling signal when the power supply voltage at the power output drops to a set value;
a control unit (203), wherein the control unit (203) comprises: an oscillator (2031), a pulse generator (2032) and an "OR" operation unit;
wherein the oscillator (2031) is connected to an output of the enabling unit (202), wherein the oscillator (2031) is configured to, when triggered by the rising edge of the enabling signal, which forms a high level of said enabling signal, generate a delayed pulse control signal with a certain period, and wherein the oscillator is configured to be turned off when the enabling signal is a low level;
wherein the pulse generator (2032) is connected to the output of the enabling unit (202), and is configured to generate synchronously an instant pulse control signal at the time of receiving the rising edge of the enabling signal, wherein a pulse width of the instant pulse control signal is the same as a pulse width of the delayed pulse control signal generated by the oscillator (2031); and
wherein the "OR" operation unit (2033) is connected to an output of the oscillator (2031) and an output of the pulse generator (2032), and wherein the "OR" operation unit (2033) is configured to perform an "OR" operation on the delayed pulse control signal and the instant pulse control signal to generate a boost control signal;
wherein an output of the control unit (203) is connected to the boosting unit (201), and the control unit is configured to output the boost control signal to the boosting unit (201) to boost the power supply voltage;
wherein the pulse generator (2032) comprises a delay inversion circuit (601) and an "AND" operation unit (602); wherein an input of the delay inversion circuit (601) is connected to the output of the enabling unit (202), and is configured to invert the enabling signal and output the inverted enabling signal with a delay; wherein the "AND" operation unit (602) is connected to the output of the delay inversion circuit (601) and the output of the enabling unit (202), and is configured to perform an "AND" operation on the signal from the delay inversion circuit and the enabling signal;
wherein the delay inversion circuit (601) comprises: a first invertor, a resistor and a capacitor, wherein an input of the first invertor is connected to the output of the enabling unit (202), an output of the first invertor is connected to a first terminal of the resistor, a second terminal of the resistor is connected to a first terminal of the capacitor, and a second terminal of the capacitor is grounded, and wherein the first terminal of the capacitor serves as the output of the delay inversion circuit (601); or,
wherein the delay inversion circuit (601) comprises: a first invertor, a second invertor, a third invertor, a first capacitor, and a second capacitor; wherein an input of the first invertor is connected to the output of the enabling unit (202), an output of the first invertor is connected to a first terminal of the first capacitor and a first terminal of the second invertor; wherein an output of the second invertor is connected to a first terminal of the second capacitor and an input of the third invertor; wherein second terminals of the first capacitor and the second capacitor are grounded; and wherein an output of the third invertor is used as the output of the delay inversion circuit (601).

2. The power module according to claim 1, wherein the boosting unit (201) is a charge pump circuit (102).

3. The power module according to claim 1, wherein the enabling unit (202) further comprises: a comparator and a voltage divider circuit (2021), wherein a first terminal of the voltage divider circuit (2021) is connected to the power output, a second terminal of the boosting unit (201) is grounded; and wherein an output of the voltage divider circuit (2021) is connected to a negative input of the comparator, a positive input of the comparator is connected to a reference voltage terminal, and a voltage value at the reference voltage terminal is a set value.

4. The power module according to claim 3, wherein the voltage divider circuit (2021) further comprises: a first voltage dividing resistor and a second voltage dividing resistor, wherein a first terminal of the first voltage dividing resistor is connected to the power output, a second terminal of the first voltage dividing resistor is connected to a first terminal of the second voltage dividing resistor, a second terminal of the second voltage dividing resistor is grounded; and wherein a connecting terminal of the first voltage dividing resistor and the second voltage dividing resistor serves as an output of the voltage divider circuit (2021).

5. The power module according to claim 1, wherein the "OR" operation unit (2033) comprises a NOR gate and a NOT gate connected in sequence, wherein two inputs of the NOR gate are connected to the output of the pulse generator (2032) and the output of the oscillator (2031) respectively, wherein an output of the NOR gate is connected to an input of the NOT gate, and wherein an output of the NOT gate is connected to an input of the boosting unit (201).

6. The power module according to claim 1, wherein the "AND" operation unit (602) comprises a NAND gate and a NOT gate connected to the NAND gate.

7. The power module according to claim 1, wherein a first rising edge of the instant pulse control signal and the rising edge of the enabling signal are generated simultaneously.

8. A memory device, comprising the power module according to any of claims 1 to 7.

## Patentansprüche

1. Leistungsmodul, das umfasst:
eine Verstärkungseinheit (201), wobei die Verstärkungseinheit (201) einen Leistungsausgang zum Ausgeben einer Leistungsversorgungsspannung aufweist;
eine Freigabeeinheit (202), wobei die Freigabeeinheit (202) mit dem Leistungsausgang verbunden und so ausgelegt ist, dass sie ein Freigabesignal erzeugt, wobei eine ansteigende Flanke in dem Freigabesignal auftritt, wenn die Leistungsversorgungsspannung an dem Leistungsausgang auf einen Sollwert fällt;
eine Steuereinheit (203), wobei die Steuereinheit (203) umfasst: einen Oszillator (2031), einen Impulsgenerator (2032) und eine "ODER"-Operationseinheit;
wobei der Oszillator (2031) mit einem Ausgang der Freigabeeinheit (202) verbunden ist, wobei der Oszillator (2031) so ausgelegt ist, dass er, wenn er durch die ansteigende Flanke des Freigabesignals, das einen hohen Pegel des Freigabesignals bildet, getriggert wird, ein verzögertes Impulssteuersignal mit einer bestimmten Periode erzeugt, und wobei der Oszillator so ausgelegt ist, dass er ausgeschaltet wird, wenn das Freigabesignal ein niedriger Pegel ist;
wobei der Impulsgenerator (2032) mit dem Ausgang der Freigabeeinheit (202) verbunden ist und so ausgelegt ist, dass er synchron ein sofortiges Impulssteuersignal zum Zeitpunkt des Empfangs der ansteigenden Flanke des Freigabesignals erzeugt, wobei eine Impulsbreite des sofortigen Impulssteuersignals die gleiche ist wie eine Impulsbreite des verzögerten Impulssteuersignals, das von dem Oszillator (2031) erzeugt wird; und
wobei die "ODER"-Operationseinheit (2033) mit einem Ausgang des Oszillators (2031) und einem Ausgang des Impulsgenerators (2032) verbunden ist, und wobei die "ODER"-Operationseinheit (2033) so ausgelegt ist, dass sie eine "ODER"-Operation mit dem verzögerten Impulssteuersignal und dem sofortigen Impulssteuersignal durchführt, um ein Verstärkungssteuersignal zu erzeugen;
wobei ein Ausgang der Steuereinheit (203) mit der Verstärkungseinheit (201) verbunden ist und die Steuereinheit so ausgelegt ist, dass sie das Verstärkungssteuersignal an die Verstärkungseinheit (201) ausgibt, um die Leistungsversorgungsspannung zu erhöhen;
wobei der Impulsgenerator (2032) eine Verzögerungsinversionsschaltung (601) und eine "UND"-Operationseinheit (602) umfasst; wobei ein Eingang der Verzögerungsinversionsschaltung (601) mit dem Ausgang der Freigabeeinheit (202) verbunden ist und so ausgelegt ist, dass er das Freigabesignal invertiert und das invertierte Freigabesignal mit einer Verzögerung ausgibt; wobei die "UND"-Operationseinheit (602) mit dem Ausgang der Verzögerungsinversionsschaltung (601) und dem Ausgang der Freigabeeinheit (202) verbunden ist und so ausgelegt ist, dass sie eine "UND"-Operation mit dem Signal von der Verzögerungsinversionsschaltung und dem Freigabesignal durchführt;
wobei die Verzögerungsinversionsschaltung (601) umfasst: einen ersten Inverter, einen Widerstand und einen Kondensator, wobei ein Eingang des ersten Inverters mit dem Ausgang der Freigabeeinheit (202) verbunden ist, ein Ausgang des ersten Inverters mit einem ersten Anschluss des Widerstands verbunden ist, ein zweiter Anschluss des Widerstands mit einem ersten Anschluss des Kondensators verbunden ist und ein zweiter Anschluss des Kondensators geerdet ist, und wobei der erste Anschluss des Kondensators als der Ausgang der Verzögerungsinversionsschaltung (601) dient; oder,
wobei die Verzögerungsinversionsschaltung (601) umfasst: einen ersten Inverter, einen zweiten Inverter, einen dritten Inverter, einen ersten Kondensator und einen zweiten Kondensator; wobei ein Eingang des ersten Inverters mit dem Ausgang der Freigabeeinheit (202) verbunden ist, ein Ausgang des ersten Inverters mit einem ersten Anschluss des ersten Kondensators und einem ersten Anschluss des zweiten Inverters verbunden ist; wobei ein Ausgang des zweiten Inverters mit einem ersten Anschluss des zweiten Kondensators und einem Eingang des dritten Inverters verbunden ist; wobei zweite Anschlüsse des ersten Kondensators und des zweiten Kondensators geerdet sind; und wobei ein Ausgang des dritten Inverters als der Ausgang der Verzögerungsinversionsschaltung (601) verwendet wird.

2. Leistungsmodul nach Anspruch 1, wobei die Verstärkungseinheit (201) eine Ladungspumpenschaltung (102) ist.

3. Leistungsmodul nach Anspruch 1, wobei die Freigabeeinheit (202) ferner umfasst: einen Komparator und eine Spannungsteilerschaltung (2021), wobei ein erster Anschluss der Spannungsteilerschaltung (2021) mit dem Leistungsausgang verbunden ist, ein zweiter Anschluss der Verstärkungseinheit (201) geerdet ist; und wobei ein Ausgang der Spannungsteilerschaltung (2021) mit einem negativen Eingang des Komparators verbunden ist, ein positiver Eingang des Komparators mit einem Referenzspannungsanschluss verbunden ist und ein Spannungswert an dem Referenzspannungsanschluss ein Sollwert ist.

4. Leistungsmodul nach Anspruch 3, wobei die Spannungsteilerschaltung (2021) ferner umfasst: einen ersten Spannungsteilungswiderstand und einen zweiten Spannungsteilungswiderstand, wobei ein erster Anschluss des ersten Spannungsteilungswiderstandes mit dem Leistungsausgang verbunden ist, ein zweiter Anschluss des ersten Spannungsteilungswiderstandes mit einem ersten Anschluss des zweiten Spannungsteilungswiderstandes verbunden ist, ein zweiter Anschluss des zweiten Spannungsteilungswiderstandes geerdet ist; und wobei ein Verbindungsanschluss des ersten Spannungsteilungswiderstandes und des zweiten Spannungsteilungswiderstandes als ein Ausgang der Spannungsteilerschaltung (2021) dient.

5. Leistungsmodul nach Anspruch 1, wobei die "ODER"-Operationseinheit (2033) ein NOR-Gatter und ein NICHT-Gatter umfasst, die in Reihe geschaltet sind, wobei zwei Eingänge des NOR-Gatters jeweils mit dem Ausgang des Impulsgenerators (2032) und dem Ausgang des Oszillators (2031) verbunden sind, wobei ein Ausgang des NOR-Gatters mit einem Eingang des NICHT-Gatters verbunden ist, und wobei ein Ausgang des NICHT-Gatters mit einem Eingang der Verstärkungseinheit (201) verbunden ist.

6. Leistungsmodul nach Anspruch 1, wobei die "UND"-Operationseinheit (602) ein NAND-Gatter und ein mit dem NAND-Gatter verbundenes NICHT-Gatter umfasst.

7. Leistungsmodul nach Anspruch 1, wobei eine erste ansteigende Flanke des sofortigen Impulssteuersignald und die ansteigende Flanke des Freigabesignals gleichzeitig erzeugt werden.

8. Speichervorrichtung, die das Leistungsmodul nach einem der Ansprüche 1 bis 7 umfasst.

## Revendications

1. Module d'alimentation, comprenant
une unité d'élévation de tension (201), dans lequel l'unité d'élévation de tension (201) a une sortie d'alimentation pour délivrer une tension d'alimentation ;
une unité de validation (202), dans lequel l'unité de validation (202) est connectée à la sortie d'alimentation et est configurée pour générer un signal de validation, dans lequel un front montant se produit dans le signal de validation lorsque la tension d'alimentation à la sortie d'alimentation chute à un valeur de consigne ;
une unité de commande (203), dans lequel l'unité de commande (203) comprend: un oscillateur (2031), un générateur d'impulsions (2032) et une unité d'opération "OU";
dans lequel l'oscillateur (2031) est connecté à une sortie de l'unité de validation (202), dans lequel l'oscillateur (2031) est configuré pour, lorsqu'il est déclenché par le front montant du signal de validation, qui forme un niveau haut dudit signal de validation, générer un signal de commande d'impulsion retardé avec une certaine période, et dans lequel l'oscillateur est configuré pour être désactivé lorsque le signal de validation est à un niveau bas ;
dans lequel le générateur d'impulsions (2032) est connecté à la sortie de l'unité de validation (202), et est configuré pour générer de manière synchrone un signal de commande d'impulsion instantané au moment de la réception du front montant du signal de validation, dans lequel une largeur d'impulsion de l'instant le signal de commande d'impulsion est le même qu'une largeur d'impulsion du signal de commande d'impulsion retardé généré par l'oscillateur (2031) ; et
dans lequel l'unité d'opération "OU" (2033) est connectée à une sortie de l'oscillateur (2031) et à une sortie du générateur d'impulsions (2032), et dans lequel l'unité d'opération "OU" (2033) est configurée pour effectuer une opération "OU" sur le signal de commande d'impulsion retardé et le signal de commande d'impulsion instantané pour générer un signal de commande d'élévation de tension,
dans lequel une sortie de l'unité de commande (203) est connectée à l'unité d'élévation de tension (201), et l'unité de commande est configurée pour émettre le signal de commande d'élévation de tension à l'unité d'élévation de tension (201) pour élever la tension la tension d'alimentation ;
dans lequel le générateur d'impulsions (2032) comprend un circuit d'inversion de retard (601) et une unité d'opération "ET" (602); dans lequel une entrée du circuit d'inversion de retard (601) est connectée à la sortie de l'unité de validation (202), et est configurée pour inverser le signal de validation et sortir le signal de validation inversé avec un retard ; dans lequel l'unité d'opération "ET" (602) est connectée à la sortie du circuit d'inversion de retard (601) et à la sortie de l'unité de validation (202), et est configurée pour effectuer une opération "ET" sur le signal provenant du circuit de retard circuit d'inversion et le signal de validation ;
dans lequel le circuit d'inversion de retard (601) comprend : un premier inverseur, une résistance et un condensateur, dans lequel une entrée du premier inverseur est connectée à la sortie de l'unité de validation (202), une sortie du premier inverseur est connectée à un première borne de la résistance, une seconde borne de la résistance est connectée à une première borne du condensateur, et une seconde borne du condensateur est mise à la terre, et dans lequel la première borne du condensateur sert de sortie du circuit d'inversion de retard (601); ou,
dans lequel le circuit d'inversion de retard (601) comprend : un premier inverseur, un deuxième inverseur, un troisième inverseur, un premier condensateur et un deuxième condensateur ; dans lequel une entrée du premier inverseur est connectée à la sortie de l'unité de validation (202), une sortie du premier inverseur est connectée à une première borne du premier condensateur et à une première borne du deuxième inverseur ; dans lequel une sortie du deuxième inverseur est connectée à une première borne du deuxième condensateur et à une entrée du troisième inverseur ; dans lequel les deuxièmes bornes du premier condensateur et du deuxième condensateur sont mises à la masse ; et dans lequel une sortie du troisième inverseur est utilisée comme sortie du circuit d'inversion de retard (601).

2. Module d'alimentation selon la revendication 1, dans lequel l'unité d'élévation de tension (201) est un circuit de pompe de charge (102).

3. Module d'alimentation selon la revendication 1, dans lequel l'unité de validation (202) comprend en outre :
un comparateur et un circuit diviseur de tension (2021), dans lequel une première borne du circuit diviseur de tension (2021) est connectée à la sortie d'alimentation, une seconde borne de l'unité d'élévation de tension (201) est mise à la masse ; et dans lequel une sortie du circuit diviseur de tension (2021) est connectée à une entrée négative du comparateur, une entrée positive du comparateur est connectée à une borne de tension de référence, et une valeur de tension à la borne de tension de référence est une valeur définie.

4. Module d'alimentation selon la revendication 3, dans lequel le circuit diviseur de tension (2021) comprend en outre : une première résistance de division de tension et une deuxième résistance de division de tension, dans lequel une première borne de la première résistance de division de tension est connectée à la sortie d'alimentation, une deuxième borne de la première résistance de division de tension est connectée à une première borne de la deuxième résistance de division de tension, une deuxième borne de la deuxième résistance de division de tension est mise à la masse ; et dans lequel une borne de connexion de la première résistance de division de tension et de la deuxième résistance de division de tension sert de sortie du circuit diviseur de tension (2021).

5. Module d'alimentation selon la revendication 1, dans lequel l'unité d'opération "OU" (2033) comprend une porte NOR et une porte NON connectées en séquence, dans lequel deux entrées de la porte NOR sont connectées à la sortie du générateur d'impulsions (2032 ) et la sortie de l'oscillateur (2031) respectivement, dans lequel une sortie de la porte NOR est connectée à une entrée de la porte NOT, et dans lequel une sortie de la porte NOT est connectée à une entrée de l'unité d'élévation de tension (201).

6. Module d'alimentation selon la revendication 1, dans lequel l'unité d'opération "ET" (602) comprend une porte NAND et une porte NON connectée à la porte NAND.

7. Module d'alimentation selon la revendication 1, dans lequel un premier front montant du signal impulsionnel instantané de commande et le front montant du signal de validation sont générés simultanément.

8. Dispositif de mémoire, comprenant le module d'alimentation selon l'une quelconque des revendications 1 à 7.
